# EUROPÄISCHE PATENTSCHRIFT

(11) **EP 1 132 917 B1**
(45) Veröffentlichungstag und Bekanntmachung des Hinweises auf die Patenterteilung: **23.11.2011**
(21) Anmeldenummer: 01103454.3
(22) Anmeldetag: 14.02.2001
(51) Int. Cl.: G11C 11/16, G11C 11/15

(54) **Integrierter Speicher mit Speicherzellen mit magnetoresistivem Speichereffekt**
Integrated memory with memory cells having a magneto-resistive memory effect
Mémoire intégrée ayant des cellules de mémoire à effet de mémoire magnéto-résistive

(30) Priorität: 03.03.2000 DE 10010457
(43) Veröffentlichungstag der Anmeldung: 12.09.2001
(73) Patentinhaber: Qimonda AG, 81739 München (DE)
(72) Erfinder: Schlösser, Till, Dr., 01109 Dresden (DE); Thewes, Roland, Dr., 82194 Gröbenzell (DE)
(74) Vertreter: Epping - Hermann - Fischer

(56) Entgegenhaltungen:
- US-A- 4 439 693
- US-A- 4 565 971
- US-A- 4 829 476
- US-A- 5 282 104

## Beschreibung

Die vorliegende Erfindung betrifft einen integrierten Speicher mit Speicherzellen mit magnetoresistivem Speichereffekt, mit einem matrixförmigen Speicherzellenfeld, das Spaltenleitungen und Zeilenleitungen aufweist, bei dem die Speicherzellen jeweils zwischen eine der Spaltenleitungen und eine der Zeilenleitungen geschaltet sind, bei dem die Spaltenleitungen jeweils mit einem Leseverstärker verbunden sind zum Auslesen eines Datensignals einer entsprechenden Speicherzelle, der einen rückgekoppelten Operationsverstärker aufweist, an dem ein Auslesesignal abgreifbar ist, und bei dem ein erster Steuereingang des Operationsverstärkers mit einer der Spaltenleitungen verbunden ist.

Speicherzellen mit magnetoresistivem Speichereffekt weisen zur Speicherung von Datensignalen im allgemeinen in ihrem Zustand veränderbare ferromagnetische Schichten auf. Dieser Speichereffekt ist allgemein als sogenannter GMR-Effekt (giant magnetoresistive) oder TMR-Effekt (tunneling magnetoresistive) bekannt. Dabei ist der elektrische Widerstand einer derartigen Speicherzelle abhängig von der Magnetisierung in den ferromagnetischen Schichten.

Die Druckschrift US 4,829,476 betrifft eine Speicheranordnung, bei der Speicherzellen mit magnetoresistivem Speichereffekt matrixförmig in einem Speicherzellenfeld angeordnet sind. Das Speicherzellenfeld ist ausgangsseitig mit einer Differenzverstärkerschaltung verbunden, bei der Offsetspannungen durch Kondensatoren, die den Eingängen der Differenzverstärkerschaltung vorgeschaltet sind, kompensiert werden.

In DE 197 40 942.3 ist eine Speicherzellenanordnung und deren Verwendung als magnetisches RAM (sogenanntes MRAM) beschrie ben. Die Speicherzellenanordnung weist untereinander im wesentlichen parallel verlaufende Zeilenleitungen und Spaltenleitungen auf, wobei die Zeilenleitungen quer zu den Spaltenleitungen verlaufen. Es sind Speicherzellen mit magnetoresistivem Speichereffekt vorgesehen, die jeweils zwischen eine der Zeilenleitungen und einer der Spaltenleitungen geschaltet sind und die hochohmiger als die Zeilenleitungen und die Spaltenleitungen sind. Die Spaltenleitungen sind jeweils mit einem Leseverstärker verbunden zum Auslesen eines Datensignals einer der Speicherzellen, über den das Potential an der jeweiligen Spaltenleitung auf ein Versorgungs- bzw. Referenzpotential regelbar ist. Zum Auslesen wird der auf der Spaltenleitung detektierbare Strom gemessen.

Der Leseverstärker weist einen rückgekoppelten Operationsverstärker auf, an dem ein Ausgangssignal abgreifbar ist. Der nicht invertierende Eingang des Operationsverstärkers ist dabei mit einem Referenzpotential verbunden. Eine der Spaltenleitungen ist mit dem invertierenden Eingang verbunden. Entspricht das Referenzpotential beispielsweise einem Massepotential des integrierten Speichers, so stellt der Operationsverstärker sicher, daß an der Spaltenleitung ebenfalls im wesentlichen Massepotential anliegt. Der Leseverstärker wird daher auch als sogenannter "Virtual Ground" Leseverstärker bezeichnet. Das Ausgangssignal des Operationsverstärkers ist ein Maß für den Widerstand der ausgewählten Speicherzelle.

Bei einem derart angeordneten MRAM-Speicher sind keine Dioden oder Transistoren vorhanden, die abhängig von der Adressierung die Speicherzellen mit den Spaltenleitungen zum Auslesen eines Datensignals verbinden. Aus diesem Grund ist es wichtig, daß alle Spaltenleitungen während des Lesevorgangs an dem gleichen Potential anliegen, um parasitäre Ströme im Speicherzellenfeld zu vermeiden.

Die im beschriebenen Leseverstärker enthaltene Operationsverstärkerschaltung weist im allgemeinen eine sogenannte Offset-Spannung auf, die üblicherweise technologisch bedingt ist. Das heißt, die Einsatzspannungen und die Gate-Source-Spannungen der Eingangstransistoren sind nicht genau gleich. Dadurch wird das Potential der jeweiligen Spaltenleitung nicht genau auf das vorhandene Referenzpotential geregelt. Eine Offset-Spannung von bereits wenigen Millivolt kann in vergleichsweise großen Speicherzellenfeldern parasitäre Ströme hervorrufen. Diese parasitären Ströme können größer sein als ein auszulesendes Datensignal oder Meßsignal. Dieses kann dabei so verfälscht werden, daß es nicht mehr detektiert werden kann.

Die Aufgabe der vorliegenden Erfindung ist es, einen integrierten Speicher der eingangs genannten Art anzugeben, bei dem eine vergleichsweise sichere Detektierbarkeit eines auszulesenden Datensignals ermöglicht ist.

Die Aufgabe wird gelöst durch einen integrierten Speicher mit Speicherzellen mit magnetoresistivem Speichereffekt, mit einem matrixförmigen Speicherzellenfeld, das Spaltenleitungen und Zeilenleitungen aufweist, bei dem die Speicherzellen jeweils zwischen eine der Spaltenleitungen und eine der Zeilenleitungen geschaltet sind, bei dem die Spaltenleitungen jeweils mit einem Leseverstärker verbunden sind zum Auslesen eines Datensignals einer entsprechenden Speicherzelle, bei dem der Leseverstärker einen rückgekoppelten Operationsverstärker aufweist, an dem ein Auslesesignal abgreifbar ist, bei dem ein erster Steuereingang des Operationsverstärkers mit einer der Spaltenleitungen verbunden ist, und bei dem zwischen einen zweiten Steuereingang des Operationsverstärkers und einen Anschluß für ein Versorgungspotential ein Kondensator geschaltet ist.

Zwischen den ersten Steuereingang des Operationsverstärkers und den Anschluß für das Versorgungspotential ist ein erster Schalter geschaltet, in den Rückkopplungspfad des Operationsverstärkers ist ein zweiter Schalter geschaltet, und ein Ausgang des Operationsverstärkers ist über einen dritten Schalter mit dem zweiten Steuereingang verbunden.

Mit dem erfindungsgemäßen integrierten Speicher werden parasitäre Ströme in dem Speicherzellenfeld bei einer vorhandenen Offset-Spannung eines in dem Leseverstärker enthaltenen Operationsverstärkers vermieden. Der integrierte Speicher beinhaltet eine Schaltungsanordnung zur Kompensation einer vorhandenen Offset-Spannung. Mit dieser Schaltungsanordnung ist es möglich, eine vorhandene Offset-Spannung des Operationsverstärkers in dem Kondensator zu speichern, der zwischen den zweiten Steuereingang des Operationsverstärkers und den Anschluß für das Versorgungspotential, zum Beispiel ein Bezugspotential des Speichers, geschaltet ist. Dadurch kann die Wirkung der Offset-Spannung des Operationsverstärkers durch eine betragsgleiche Spannung an dem Kondensator aufgehoben werden. Damit wird das Potential der jeweiligen Spaltenleitung am ersten Steuereingang des Operationsverstärkers auf das Versorgungspotential bzw. Bezugspotential geregelt. Dadurch können keine parasitären Ströme auftreten, die ein auszulesendes Meßsignal verfälschen können.

Das an dem Kondensator anliegende Potential kann beispielsweise in jedem Lesezyklus abgeglichen werden. Zum Auslesen eines Datensignals einer Speicherzelle werden alle nicht ausgewählten Zeilenleitungen auf das Versorgungspotential gelegt. An die ausgewählte Zeilenleitung wird ein Signal mit einem dazu unterschiedlichen Potential angelegt. Dadurch wird ein Strompfad von der ausgewählten Zeilenleitung zu allen Spaltenleitungen geschlossen. Aus dem Ausgangssignal an dem jeweiligen Leseverstärker, den elektrischen Kenngrößen des Leseverstärkers und dem Versorgungspotential sowie dem Spaltenleitungswiderstand läßt sich der Widerstand der am Kreuzungspunkt der Zeilenleitung mit der jeweiligen Spaltenleitung befindlichen Speicherzelle bestimmen. Nachdem das Ausgangssignal des Leseverstärkers von weiteren Schaltungsteilen gegebenenfalls zwischengespeichert, bewertet oder in anderer allgemeiner Form weiterverarbeitet worden ist, kann wieder ein Abgleich der Offset-Spannung erfolgen. Dabei ist es jedoch auch möglich, die Offset-Spannung nicht nach jedem Bewertungsvorgang zwischenzuspeichern, sondern einen Abgleich nur jeweils nach einer größeren Anzahl von Bewertungsvorgängen vorzunehmen.

Vorteilhafte Aus- und Weiterbildungen sind Gegenstand abhängiger Ansprüche. Eine Abgleichphase zur Abgleichung der Offset-Spannung liegt zwischen zwei Bewertungsvorgängen. Dazu wird in der Abgleichphase der zweite Schalter geöffnet und damit die Gegenkopplung des Operationsverstärkers aufgetrennt. Der erste Schalter und der dritte Schalter werden geschlossen. Dadurch wird ein geschlossener Regelkreis hergestellt, der die Offset-Spannung des Operationsverstärkers auf den Kondensator lädt. Für einen anschließenden Bewertungsvorgang werden der erste Schalter und der dritte Schalter wieder geöffnet, der zweite Schalter wird geschlossen, und ein auszulesendes Datensignal dem Leseverstärker zugeführt.

In einer Weiterbildung der Erfindung ist der rückgekoppelte Operationsverstärker als invertierender Verstärker ausgebildet. Das heißt, die jeweilige Spaltenleitung ist an den invertierenden Steuereingang angeschlossen. Dabei ist zwischen den Ausgang und den zweiten Steuereingang des Operationsverstärkers eine invertierende Schaltung geschaltet. Dadurch wird die richtige Polarität der in dem Kondensator zu speichernden Offset-Spannung erreicht.

In den Rückkopplungspfad des Operationsverstärkers ist beispielsweise ein Widerstand geschaltet. Der rückgekoppelte Operationsverstärker verhält sich dabei als Strom-Spannungs-Verstärker. Zusätzlich oder alternativ dazu ist in den Rückkopplungspfad ein weiterer Kondensator geschaltet. Der rückgekoppelte Operationsverstärker wirkt dabei als integrierender Strom-Spannungs-Verstärker. Dadurch kann eine wirksame Rauschunterdrückung beim Auslesen eines Datensignals erzielt werden.

Um während einer Abgleichphase den weiteren Kondensator zu entladen, ist in den Rückkopplungspfad des Operationsverstärkers ein vierter Schalter parallel zu dem weiteren Kondensator geschaltet. Während einer Abgleichphase wird dieser Schalter geschlossen, für einen Bewertungsvorgang ist der vierte Schalter geöffnet.

Die Erfindung wird im folgenden anhand der in der Zeichnung dargestellten Figuren näher erläutert. Es zeigen:
- Figur 1: eine Ausführungsform des erfindungsgemäßen Spei- chers mit magnetoresistiven Speicherzellen,
- Figur 2: eine Ausführungsform eines Leseverstärkers,
- Figur 3: eine weitere Ausführungsform eines Leseverstärkers.

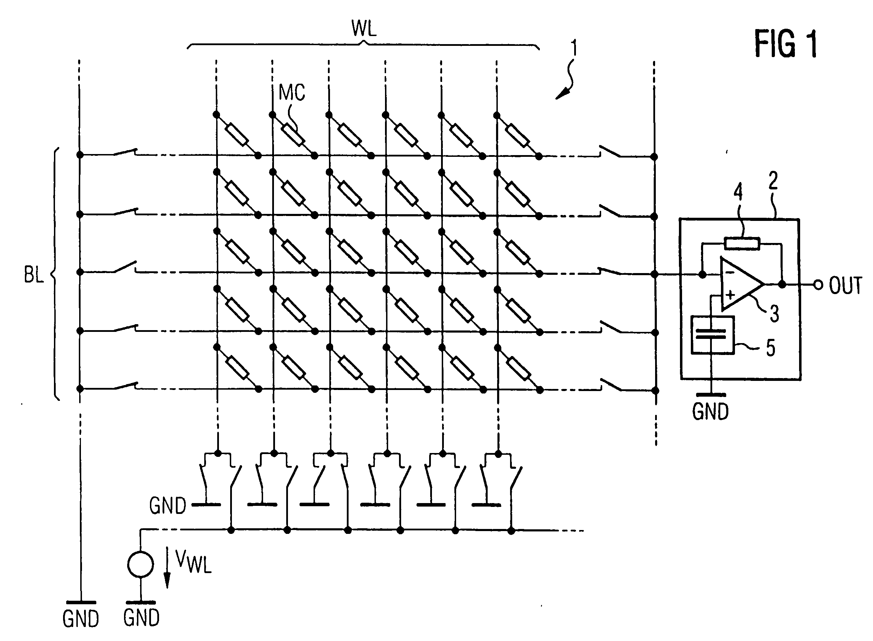

Figur 1 zeigt ein Ausführungsbeispiel eines Speichers gemäß dem Stand der Technik mit Speicherzellen MC mit magnetoresistivem Speichereffekt. Als Speicherzellen sind alle bekannten GMR-/TMR-Elemente geeignet, sofern sie hochohmiger als die Spaltenleitungen bzw. Bitleitungen BL und die Zeilenleitungen bzw. Wortleitungen WL sind. Die Speicherzellen MC, die in einem matrixförmigen Speicherzellenfeld 1 angeordnet sind, sind jeweils zwischen eine der Bitleitungen BL und eine der Wortleitungen WL geschaltet. Zum Auslesen eines Datensignals einer der Speicherzellen MC ist die entsprechende Bitleitung mit einem Leseverstärker 2 verbunden. Die übrigen Bitleitungen BL sind ebenfalls an weiteren Leseverstärkern angeschlossen oder, wie in Figur 1 dargestellt, mit einem Anschluß für ein Bezugspotential GND verbunden. Der Leseverstärker 2 weist einen rückgekoppelten Operationsverstärker 3 auf, an dem das Auslesesignal OUT abgreifbar ist.

Zum Auslesen der in der Speicherzellenanordnung gespeicherten Information wird die betreffende Wortleitung WL angesteuert. Dazu wird die Wortleitung WL auf ein Potential V_{WL} gelegt. Alle anderen Wortleitungen WL werden auf Bezugspotential GND gelegt. Zum Auslesen des Datensignals ist die betreffende Bitleitung BL mit dem invertierenden Eingang 31 des Operationsverstärkers 3 verbunden. Zwischen den nicht invertierenden Eingang 32 des Operationsverstärkers 3 und den Anschluß für das Bezugspotential GND ist der Kondensator 5 geschaltet.

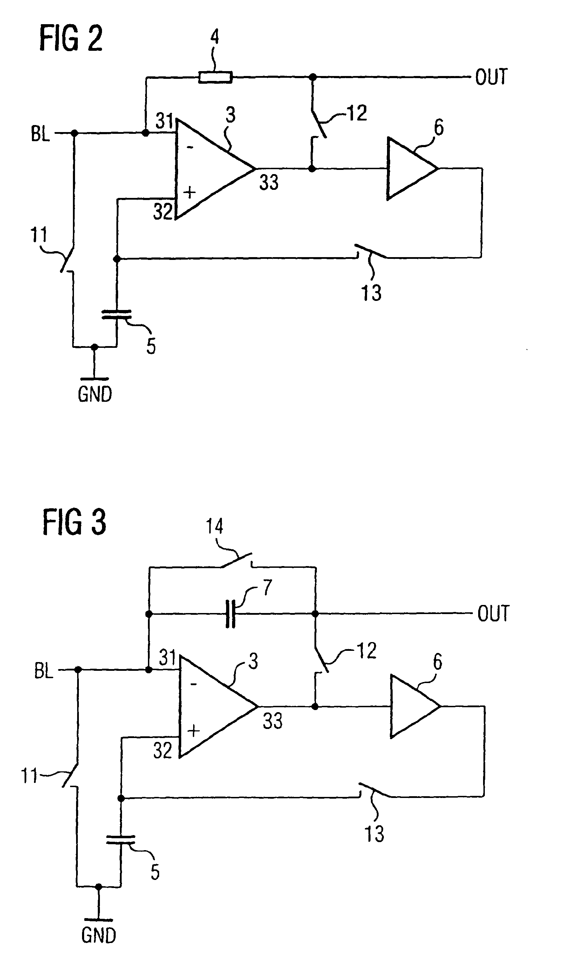

Figur 2 stellt eine Ausführungsform des Leseverstärkers 2 aus Figur 1 dar. Zwischen den invertierenden Eingang 31 des Operationsverstärkers 3 und den Anschluß für das Bezugspotential GND ist ein Schalter 11 geschaltet. Ein weiterer Schalter 12 ist in den Rückkopplungspfad des Operationsverstärkers 3 geschaltet. Ein Ausgang 33 des Operationsverstärkers 3 ist über einen Schalter 13 mit dem nicht invertierenden Eingang 32 des Operationsverstärkers 3 verbunden. Weiterhin ist zwischen den Ausgang 33 und den nicht invertierenden Eingang 32 des Operationsverstärkers 3 eine invertierende Schaltung 6 geschaltet. Der Operationsverstärker 3 weist einen Rückkopplungswiderstand 4 auf, der in den Rückkopplungspfad geschaltet ist.

Zur Kompensation der Offset-Spannung des Operationsverstärkers 3 wird in einer Abgleichphase zwischen zwei Bewertungsvorgängen die Offset-Spannung im Kondensator 5 gespeichert. Dazu wird der Schalter 12 geöffnet und damit die Gegenkopplung des Operationsverstärkers 3 aufgetrennt. Die Schalter 11 und 13 werden geschlossen. Über die invertierende Schaltung 6 wird ein geschlossener Regelkreis hergestellt, der die Offset-Spannung am Eingang des Operationsverstärkers 3 auf den Kondensator 5 lädt.

Zum Auslesen eines Datensignals einer der Speicherzellen MC werden die Schalter 11 und 13 wieder geöffnet, der Schalter 12 wird geschlossen. Nach Beendigung des Lesevorgangs kann ein erneuter Abgleich vorgenommen werden, es ist jedoch auch möglich, nach einer größeren Anzahl von Lesevorgängen einen erneuten Abgleich vorzunehmen. Ein Vorteil der Schaltungsanordnung nach Figur 2 ist, daß die Kompensation der Offset-Spannung in selbstjustierender Weise vorgenommen wird.

In Figur 3 ist eine weitere Ausführungsform des Leseverstärkers 2 dargestellt, die hier anstelle des Widerstands 4 einen weiteren Kondensator 7 im Rückkopplungspfad des Operationsverstärkers vorsieht. In den Rückkopplungspfad ist außerdem ein Schalter 14 parallel zu dem Kondensator 7 geschaltet. Durch das Vorsehen des Kondensators 7 im Rückkopplungspfad ist eine weitgehende Rauschunterdrückung beim Auslesen eines Datensignals auch bei vergleichsweise kleinen Signalstärken ermöglicht. Während einer Abgleichphase wird der Schalter 14 zum Entladen des Kondensators 7 geschlossen. Während eines Lesevorgangs ist der Schalter 14 geöffnet.

## Patentansprüche

1. Integrierter Speicher
- mit Speicherzellen (MC) mit magnetoresistivem Speichereffekt,
- mit einem matrixförmigen Speicherzellenfeld (1), das Spaltenleitungen (BL) und Zeilenleitungen (WL) aufweist,
- bei dem die Speicherzellen (MC) jeweils zwischen eine der Spaltenleitungen (BL) und eine der Zeilenleitungen (WL) geschaltet sind,
- bei dem die Spaltenleitungen (BL) jeweils mit einem Leseverstärker (2) verbunden sind zum Auslesen eines Datensignals einer entsprechenden Speicherzelle (MC),
- bei dem der Leseverstärker (2) einen rückgekoppelten Operationsverstärker (3) aufweist, an dem ein Auslesesignal (OUT) abgreifbar ist,
- bei dem ein erster Steuereingang (31) des Operationsverstärkers (3) mit einer der Spaltenleitungen (BL) verbunden ist,
- bei dem zwischen einen zweiten Steuereingang (32) des Operationsverstärkers (3) und einen Anschluß für ein Versorgungspotential (GND) ein Kondensator (5) geschaltet ist,
- bei dem in den Rückkopplungspfad des Operationsverstärkers (3) ein zweiter Schalter (12) geschaltet ist,
**dadurch gekennzeichnet, daß**
zwischen den ersten Steuereingang (31) und den Anschluß für das Versorgungspotential (GND) ein erster Schalter (11) geschaltet ist, ein Ausgang (33) des Operationsverstärkers (3) über einen dritten Schalter (13) mit dem zweiten Steuereingang (32) verbunden ist und zwischen den Ausgang (33) und den zweiten Steuereingang (32) des Operationsverstärkers (3) eine invertierende Schaltung (6) geschaltet ist.

2. Integrierter Speicher nach Anspruch 1,
**dadurch gekennzeichnet, daß**
der rückgekoppelte Operationsverstärker (3) als invertierender Verstärker ausgebildet ist.

3. Integrierter Speicher nach einem der Ansprüche 1 oder 2,
**dadurch gekennzeichnet, daß**
in den Rückkopplungspfad des Operationsverstärkers (3) ein Widerstand (4) geschaltet ist.

4. Integrierter Speicher nach einem der Ansprüche 1 oder 2,
**dadurch gekennzeichnet, daß**
in den Rückkopplungspfad des Operationsverstärkers (3) ein weiterer Kondensator (7) geschaltet ist.

5. Integrierter Speicher nach Anspruch 4,
**dadurch gekennzeichnet, daß**
in den Rückkopplungspfad des Operationsverstärkers (3) ein vierter Schalter (14) parallel zum weiteren Kondensator (7) geschaltet ist.

## Claims

1. An integrated memory, comprising:
- memory cells (MC) with a magnetoresistive storage effect,
- a memory cell array (1) in the form of a matrix having column lines and row lines,
- wherein the memory cells (MC) are each connected between one of the column lines (BL) and one of the row lines (WL),
- wherein the column lines (BL) are respectively connected to a read amplifier (2) for reading a data signal from a corresponding memory cell (MC),
- wherein the read amplifier (2) has an operational amplifier (3) with a feedback path, at which a read signal (OUT) may be output,
- wherein a first control input (31) of the operational amplifier (3) is connected to one of the column lines (BL),
- wherein a capacitor (5) is connected between a second control input (32) of the operational amplifier (3) and the terminal of a supply potential (GND),
- wherein a second switch (12) is connected in the feedback path of the operational amplifier (3),
**characterized in that**
a first switch (11) is connected between the first control input (31) and the terminal for the supply potential (GND), an output (33) of the operational amplifier (3) is connected to the second control input (32) by a third switch (13), and an inverting circuit (6) is connected between the output (33) and the second control input (32) of the operational amplifier (3).

2. The integrated memory according to claim 1, **characterized in that** the operational amplifier (3) with the feedback path is formed as an inverting amplifier.

3. The integrated memory according to any of claims 1 or 2, **characterized in that** a resistor (4) is connected in the feedback path of the operational amplifier (3).

4. The integrated memory according to any of claims 1 or 2, **characterized in that** a further capacitor (7) is connected in the feedback path of the operational amplifier.

5. The integrated memory according to claim 4, **characterized in that** a fourth switch (14) is connected in parallel with the further capacitor (7) in the feedback path of the operational amplifier (3).

## Revendications

1. Mémoire intégrée
- comprenant des cellules de mémoire (MC) à effet de mémoire magnétorésistif,
- comprenant un champ de cellules de mémoire (1) en forme de matrice qui présente des lignes de colonne (BL) et des lignes de rangée (WL),
- où les cellules de mémoire (MC) sont montées chacune entre l'une des lignes de colonne (BL) et l'une des lignes de rangée (WL),
- où les lignes de colonne (BL) sont reliées chacune à un amplificateur de lecture (2) pour la lecture d'un signal de données d'une cellule de mémoire (MC) correspondante,
- où l'amplificateur de lecture (2) présente un amplificateur opérationnel (3) rétrocouplé sur lequel un signal de lecture (OUT) peut être prélevé,
- où une première entrée de commande (31) de l'amplificateur opérationnel (3) est reliée à l'une des lignes de colonne (BL),
- où un condensateur (5) est monté entre une deuxième entrée de commande (32) de l'amplificateur opérationnel (3) et un raccord pour un potentiel d'alimentation (GND),
- où un deuxième interrupteur (12) est monté dans le chemin de rétroaction de l'amplificateur opérationnel (3),
**caractérisée en ce que**
un premier interrupteur (11) est monté entre la première entrée de commande (31) et le raccord pour le potentiel d'alimentation (GND), une sortie (33) de l'amplificateur opérationnel (3) est reliée à la deuxième entrée de commande (32) via un troisième interrupteur (13) et un circuit inverseur (6) est monté entre la sortie (33) et la deuxième entrée de commande (32) de l'amplificateur opérationnel (3).

2. Mémoire intégrée selon la revendication 1,
**caractérisée en ce que**
l'amplificateur opérationnel (3) rétrocouplé est configuré comme amplificateur inverseur.

3. Mémoire intégrée selon l'une des revendications 1 ou 2,
**caractérisée en ce que**
une résistance (4) est montée dans le chemin de rétrocouplage de l'amplificateur opérationnel (3).

4. Mémoire intégrée selon l'une des revendications 1 ou 2,
**caractérisée en ce que**
un condensateur supplémentaire (7) est monté dans le chemin de rétrocouplage de l'amplificateur opérationnel (3).

5. Mémoire intégrée selon la revendication 4,
**caractérisée en ce que**
un quatrième interrupteur (14) est monté en parallèle au condensateur supplémentaire (7) dans le chemin de rétrocouplage de l'amplificateur opérationnel (3).
